# EUROPEAN PATENT APPLICATION

(11) **EP 4 651 270 A1**
(43) Date of publication of application: **19.11.2025**
(21) Application number: 25171871.4
(22) Date of filing: 23.04.2025
(51) Int. Cl.: H01M 10/613, H01M 50/204, H01M 50/271, H01M 50/287, H01M 50/289, H01M 50/367, B60L 50/64, H01M 10/42, B60K 1/00

(54) **POWER STORAGE DEVICE**

(30) Priority: 16.05.2024 JP 2024080012
(71) Applicant: TOYOTA JIDOSHA KABUSHIKI KAISHA, Toyota-shi, Aichi-ken 471-8571 (JP)
(72) Inventor: INOUE, Shigeyuki, Toyota-shi, 471-8571 (JP); SUGIE, Kazuki, Toyota-shi, 471-8571 (JP); KUMAZAWA, Kazuya, Toyota-shi, 471-8571 (JP); YONEZAWA, Shota, Toyota-shi, 471-8571 (JP)
(74) Representative: TBK

(57) **Abstract**

A power storage device (10) includes: at least one power storage cell (100); an upper cover (320) disposed above the at least one power storage cell; a cooler (200) disposed above the upper cover to cool the at least one power storage cell; and a junction box (842) provided above the upper cover. The cooler (200) is in thermal contact with both the at least one power storage cell and the junction box.

## Description

### CROSS REFERENCE TO RELATED APPLICATIONS

This nonprovisional application is based on Japanese Patent Application No. 2024-080012 filed on May 16, 2024 with the Japan Patent Office, the entire contents of which are hereby incorporated by reference.

### BACKGROUND

### Field

The present disclosure relates to a power storage device.

### Description of the Background Art

For example, Japanese National Patent Publication No. 2022-525014 discloses a power battery pack including a plurality of cells and a housing device. A case of each cell has a side surface provided with an external terminal and an explosion-proof valve. A module top plate having a cooling structure is disposed on an upper surface of each of the plurality of cells.

### SUMMARY

In the power battery pack disclosed in Japanese National Patent Publication No. 2022-525014, for example, a junction box may be provided above the housing device, in which case a cooler for cooling the junction box is required.

An object of the present disclosure is to provide a power storage device capable of eliminating the need to provide a dedicated cooler for cooling a junction box.

A power storage device according to one aspect of the present disclosure includes: at least one power storage cell; an upper cover disposed above the at least one power storage cell; a cooler that cools the at least one power storage cell; and a junction box provided above the upper cover. The cooler is in thermal contact with both the at least one power storage cell and the junction box.

The foregoing and other objects, features, aspects, and advantages of the present disclosure will become apparent from the following detailed description of the present disclosure when taken in conjunction with the accompanying drawings.

### BRIEF DESCRIPTION OF THE DRAWINGS

Fig. 1 is a diagram schematically showing a vehicle including a power storage device in one embodiment of the present disclosure.
Fig. 2 is a perspective view schematically showing the power storage device and a frame member.
Fig. 3 is an exploded perspective view schematically showing the power storage device.
Fig. 4 is a cross-sectional view taken along a line IV-IV in Fig. 2.
Fig. 5 is a cross-sectional view taken along a line V-V in Fig. 4.
Fig. 6 is a plan view schematically showing a cooler.
Fig. 7 is a cross-sectional view taken along a line VII-VII in Fig. 6.
Fig. 8 is a cross-sectional view schematically showing a device unit.

### DESCRIPTION OF THE PREFERRED EMBODIMENTS

An embodiment of the present disclosure will be hereinafter described with reference to the accompanying drawings. In the drawings referred to below, the same or corresponding members are denoted by the same reference characters.

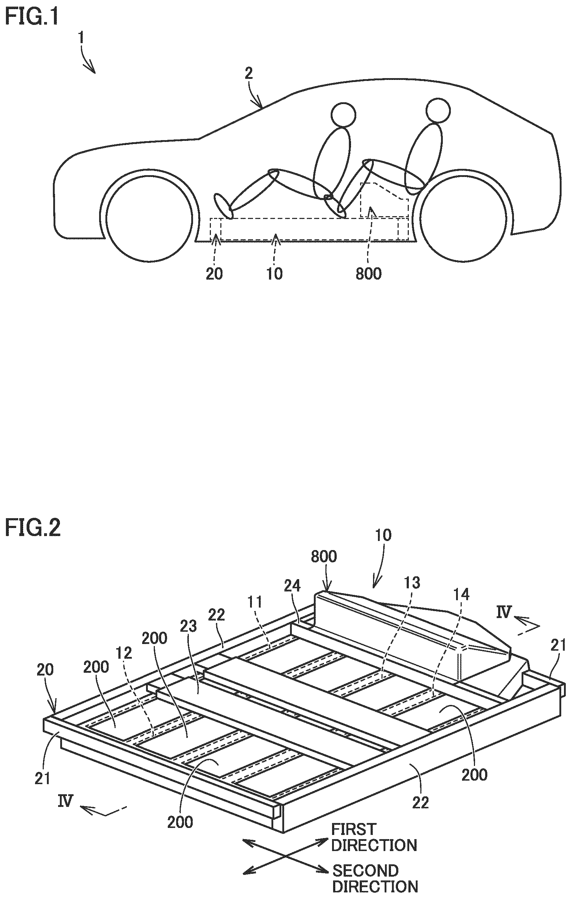

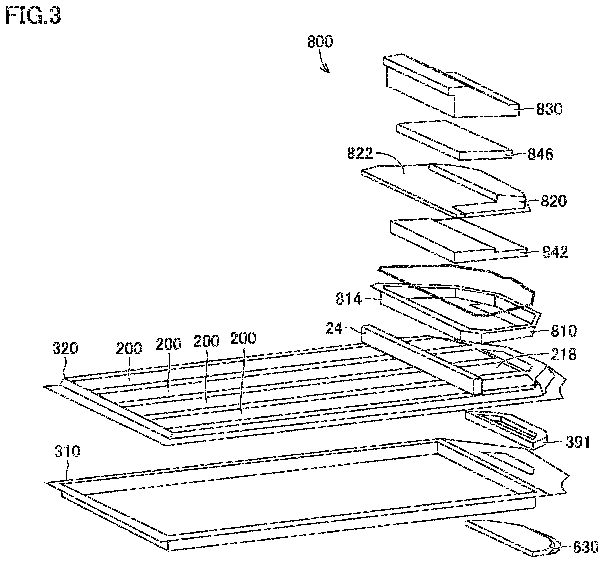

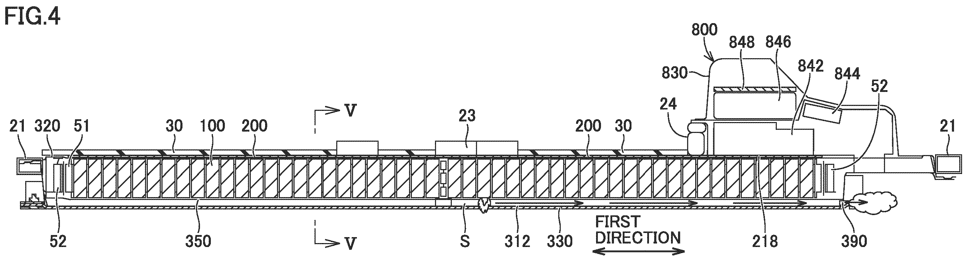

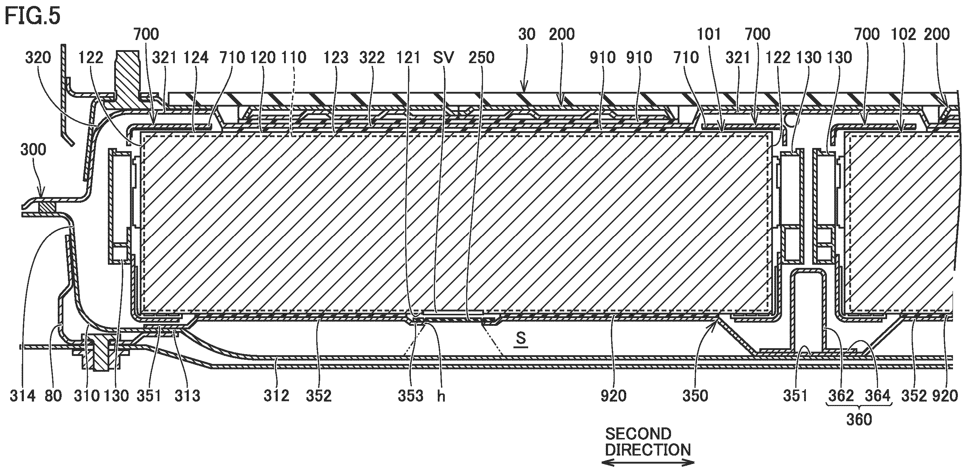

Fig. 1 is a diagram schematically showing a vehicle including a power storage device in one embodiment of the present disclosure. Fig. 2 is a perspective view schematically showing the power storage device and a frame member. Fig. 3 is an exploded perspective view schematically showing the power storage device. Fig. 4 is a cross-sectional view taken along a line IV-IV in Fig. 2. Fig. 5 is a cross-sectional view taken along a line V-V in Fig. 4.

As shown in Fig. 1, a vehicle 1 includes a vehicle body 2 and a power storage device 10. Examples of vehicle 1 include a hybrid electric vehicle, a plug-in hybrid electric vehicle, and a battery electric vehicle.

As shown in Figs. 1 and 2, vehicle body 2 includes a frame member 20. Frame member 20 is disposed on a bottom portion of vehicle body 2. Frame member 20 includes a pair of first frames 21, a pair of second frames 22, a first cross frame 23, and a second cross frame 24.

The pair of first frames 21 face each other in a first direction. Each first frame 21 is shaped to extend in a second direction orthogonal to both the first direction and an upward-downward direction. For example, the first direction may be parallel to a front-rear direction of vehicle 1, and the second direction may be parallel to a left-right direction (a width direction) of vehicle 1.

The pair of second frames 22 face each other in the second direction. Each second frame 22 is shaped to extend in the first direction. An end portion of each second frame 22 in the first direction is connected to first frame 21. The pair of second frames 22 are arranged in a substantially quadrangular cylindrical shape together with the pair of first frames 21 to surround power storage device 10.

First cross frame 23 is disposed between the pair of first frames 21 and couples the pair of second frames 22 to each other.

Second cross frame 24 is disposed between the pair of first frames 21 and couples the pair of second frames 22 to each other. Second cross frame 24 is spaced apart from first cross frame 23 in the first direction. Each of first cross frame 23 and second cross frame 24 forms, for example, a seat cross.

Power storage device 10 is attached to frame member 20. As shown in Fig. 2, power storage device 10 is disposed below first cross frame 23 and second cross frame 24. As shown in Figs. 1 to 5, power storage device 10 includes four power storage stacks 11 to 14, a cooler 200, a housing 300, a facing member 700, and a device unit 800. The number of power storage stacks is not limited to four. Fig. 3 does not show power storage stacks 11 to 14.

Each of power storage stacks 11 to 14 includes at least one power storage cell 100. In the present embodiment, each of power storage stacks 11 to 14 includes a plurality of (for example, fifty) power storage cells 100 arranged side by side in the first direction. Each of power storage stacks 11 to 14 is formed in a rectangular parallelepiped shape elongated in the first direction. As shown in Fig. 2, four power storage stacks 11 to 14 are arranged side by side in the second direction.

As shown in Fig. 4, a pair of end plates 51 that sandwich the plurality of power storage cells 100 from both sides in the first direction are provided on both sides of the plurality of power storage cells 100 in the first direction. A monitoring unit (smart battery management) 52 is disposed outside each end plate 51 in the first direction.

As shown in Fig. 5, each power storage cell 100 includes an electrode assembly 110, a cell case 120, and a pair of external terminals 130.

Electrode assembly 110 may be formed of a wound body implemented by winding a positive electrode sheet and a negative electrode sheet with a separator being interposed therebetween, or may be formed of a stacked body implemented by stacking a positive electrode sheet and a negative electrode sheet with a separator being interposed therebetween. Electrode assembly 110 is formed in a shape elongated in the second direction.

Cell case 120 accommodates electrode assembly 110. Cell case 120 is formed in a rectangular parallelepiped shape. Cell case 120 is made of metal such as aluminum. Cell case 120 includes a valve installation surface 121 and a terminal installation surface 122.

Valve installation surface 121 is provided with a safety valve SV. In the present embodiment, valve installation surface 121 is formed of a lower surface of cell case 120. In other words, safety valve SV is provided in the lower surface of cell case 120 in power storage cell 100. Fig. 5 shows two-dot chain lines indicating the discharge direction of the gas that may be discharged from safety valve SV.

External terminal 130 is provided on terminal installation surface 122. In the present embodiment, terminal installation surface 122 is formed of a side surface of cell case 120 in the second direction.

Each external terminal 130 is provided on terminal installation surface 122 (the side surface in the second direction in the present embodiment) of cell case 120. One of the pair of external terminals 130 is provided on terminal installation surface 122 on one side of cell case 120 in the second direction. The other of the pair of external terminals 130 is provided on terminal installation surface 122 on the other side of cell case 120 in the second direction.

Housing 300 accommodates at least one power storage cell 100. In the present embodiment, housing 300 accommodates four power storage stacks 11 to 14. As shown in Fig. 5, housing 300 includes a lower case 310, an upper cover 320, a panel member 330, a spacer member 350, and a cross member 360.

Lower case 310 is opened upward. Lower case 310 has a bottom surface 312 and a peripheral wall 314.

Bottom surface 312 is located below each of power storage stacks 11 to 14. Bottom surface 312 may be formed in a flat plate shape.

Peripheral wall 314 rises from a peripheral edge portion of bottom surface 312. Peripheral wall 314 is shaped to surround lower portions of power storage stacks 11 to 14.

Upper cover 320 is disposed above at least one power storage cell 100. In the present embodiment, upper cover 320 is disposed above four power storage stacks 11 to 14. Together with lower case 310, upper cover 320 accommodates four power storage stacks 11 to 14. Specifically, together with lower case 310, upper cover 320 accommodates four power storage stacks 11 to 14 in a hermetically sealed state. Upper cover 320 has a peripheral edge portion connected to a peripheral edge portion of lower case 310 with bolts or the like with a seal member being interposed therebetween.

Upper cover 320 has a top portion 321 and four recess portions 322.

Top portion 321 is formed to be flat. Top portion 321 overlaps, in the upward-downward direction, with an end portion of each power storage stack in the second direction.

Each recess portion 322 is recessed downward from top portion 321. Each recess portion 322 is formed to be flat. Each recess portion is formed above a central portion of each power storage stack in the second direction. As shown in Fig. 5, each recess portion 322 is shorter in the second direction than power storage cell 100. Each recess portion 322 is in contact with an upper surface of cell case 120 with a thermally conductive adhesive 910 being interposed therebetween.

The upper surface of cell case 120 has a contact surface 123 and a separation surface 124.

Contact surface 123 is in direct or indirect contact with upper cover 320. In the present embodiment, contact surface 123 is in contact with recess portion 322 with thermally conductive adhesive 910 being interposed therebetween.

Separation surface 124 is formed outside contact surface 123 in the second direction. Separation surface 124 is separated from upper cover 320. Separation surface 124 may be formed to be flush with contact surface 123.

Panel member 330 is provided below lower case 310. Panel member 330 has a function of protecting lower case 310. Panel member 330 may be formed in a flat plate shape. As shown in Fig. 5, panel member 330 has a peripheral edge portion connected to lower case 310 through a bracket 80.

Spacer member 350 provides a space S together with bottom surface 312 of lower case 310. Spacer member 350 is provided between bottom surface 312 of lower case 310 and at least one power storage cell 100. Specifically, spacer member 350 is provided between bottom surface 312 and each of power storage stacks 11 to 14. In other words, in the present embodiment, four spaces S are provided inside housing 300.

Each space S functions as a smoke discharge path (hereinafter referred to as a "smoke discharge path S"). Smoke discharge path S serves as a path through which the gas discharged from safety valve SV is discharged to the outside of housing 300. Each smoke discharge path S is connected to a common space inside housing 300 at an end portion of smoke discharge path S in the first direction.

Spacer member 350 has a through hole h provided below safety valve SV. When gas is discharged from safety valve SV of power storage cell 100, the gas flows into smoke discharge path S through the through hole h. In the present embodiment, through hole h is provided in a portion of spacer member 350 that faces each safety valve SV.

As shown in Fig. 4, an explosion-proof valve 390 is provided in a portion of peripheral wall 314 that faces smoke discharge path S in the first direction. Explosion-proof valve 390 is provided in a common space inside housing 300. Explosion-proof valve 390 releases the pressure inside housing 300. Explosion-proof valve 390 opens when the pressure inside housing 300 becomes equal to or higher than a reference value. Explosion-proof valve 390 is formed of a check valve. As shown in Fig. 4, when gas is discharged from one of power storage cells 100, the gas spreads in the first direction through smoke discharge path S and is discharged to the outside of housing 300 through explosion-proof valve 390.

As shown in Fig. 5, spacer member 350 includes a base portion 351 and a support portion 352.

Base portion 351 is connected to bottom surface 312 of lower case 310 by welding or the like. Base portion 351 is formed to be flat. Base portion 351 extends in the first direction.

Support portion 352 protrudes from base portion 351. Support portion 352 supports the plurality of power storage cells 100 in each power storage stack. Support portion 352 supports the plurality of power storage cells 100 with an adhesive member 920 being interposed therebetween.

Support portion 352 is provided with a mount portion 353. As shown in Fig. 5, mount portion 353 is recessed downward from support portion 352. Through hole h is provided in a portion of mount portion 353 that faces safety valve SV.

As shown in Fig. 5, a heat insulation plate 250 may be placed on mount portion 353. Heat insulation plate 250 is provided between each through hole h of spacer member 350 and safety valve SV of power storage cell 100. Each heat insulation plate 250 is made, for example, of mica obtained by hardening a natural inorganic mineral through heat pressing. Each heat insulation plate 250 is shaped to cover through hole h. A notch may be provided in a portion of each heat insulation plate 250 that overlaps with an edge portion of through hole h. Note that heat insulation plate 250 may be attached to the lower surface of cell case 120 so as to cover safety valve SV.

Cross member 360 is connected by welding or the like to a portion of base portion 351 that is located between a pair of power storage stacks adjacent to each other. For example, Fig. 5 shows cross member 360 connected to base portion 351 provided in a portion between a plurality of first power storage cells 101 (see Fig. 5) included in power storage stack 11 disposed on the outermost side in the second direction and a plurality of second power storage cells 102 (see Fig. 5) included in power storage stack 12 adjacent to power storage stack 11. Cross member 360 extends in the first direction. Cross member 360 is connected to peripheral wall 314. Cross member 360 may be connected to the pair of first frames 21 through brackets (not shown).

As shown in Fig. 5, cross member 360 has a reinforcement portion 362 and a connection bottom surface 364.

Reinforcement portion 362 is shaped to protrude in a direction away from base portion 351. Reinforcement portion 362 is disposed below external terminal 130 of power storage cell 100. Reinforcement portion 362 overlaps in the upward-downward direction with both the pair of external terminals 130 facing each other in the second direction.

Connection bottom surface 364 extends outward in the second direction from a lower end portion of reinforcement portion 362. Connection bottom surface 364 is connected to base portion 351 by welding or the like. Connection bottom surface 364 is formed to be flat.

Cooler 200 cools at least one power storage cell 100. As shown in Figs. 4, 5, and 8, cooler 200 is disposed on an upper surface of upper cover 320. Cooler 200 is in thermal contact with at least one power storage cell 100 with the upper surface of upper cover 320 being interposed therebetween. In the present embodiment, cooler 200 cools each of power storage stacks 11 to 14 through the upper surface of upper cover 320. A cooling medium (water or the like) flows through cooler 200.

As shown in Figs. 4 and 5, cooler 200 forms at least a part of a floor portion 30 of a vehicle cabin. Floor portion 30 of the vehicle cabin may include, in addition to cooler 200, floor component members (a heat insulation material, a shock absorbing member, a carpet, and the like) disposed on cooler 200. Fig. 2 does not show such floor component members.

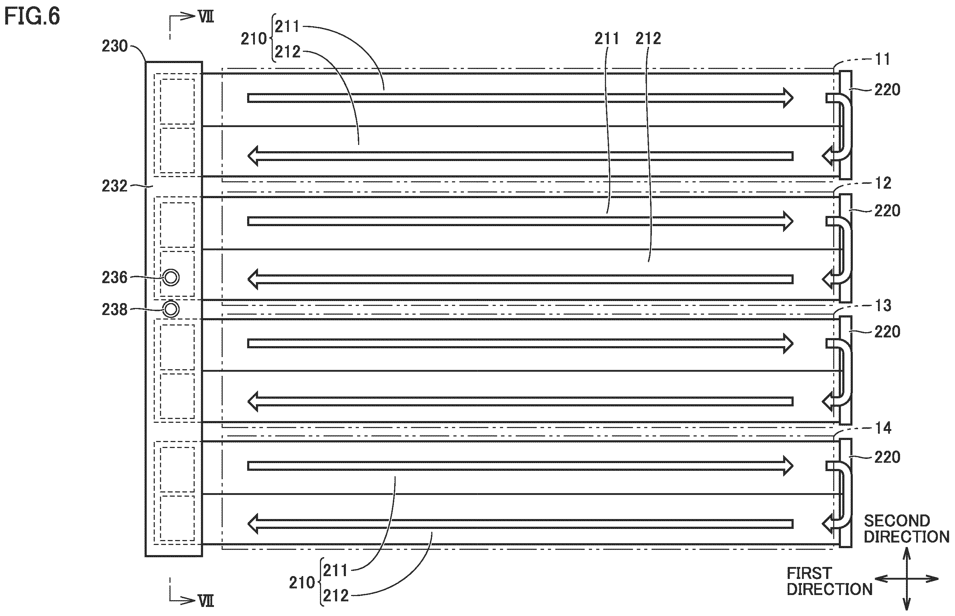

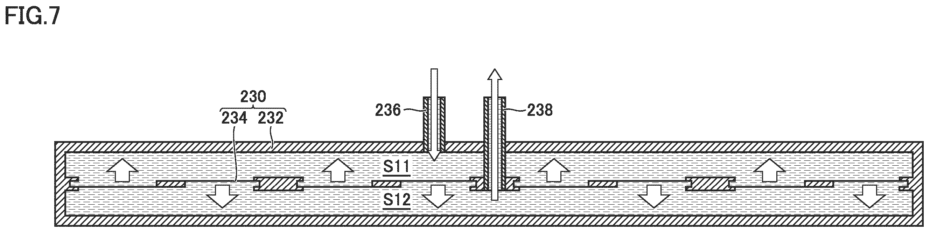

Fig. 6 is a plan view schematically showing the cooler. Fig. 7 is a cross-sectional view taken along a line VII-VII in Fig. 6. As shown in Figs. 6 and 7, cooler 200 includes four cooling portions 210, a folded portion 220, and a coupling portion 230.

Each cooling portion 210 has a shape elongated in the first direction. Each cooling portion 210 cools one power storage stack. Fig. 6 shows two-dot chain lines indicating power storage stacks 11 to 14. Each cooling portion 210 is disposed in recess portion 322 of upper cover 320. Thermally conductive adhesive 910 is provided between each cooling portion 210 and recess portion 322. Thermally conductive adhesive 910 extends in the first direction. Each cooling portion 210 is in thermal contact with the upper surface of each power storage cell 100. In the present embodiment, each cooling portion 210 is in contact with the upper surface of each power storage cell 100 with thermally conductive adhesive 910 and upper cover 320 being interposed therebetween. Note that the state of being in thermal contact includes the state in which cooling portion 210 is in contact with power storage cell 100 with only upper cover 320 being interposed therebetween, and the state in which cooling portion 210 is in indirect contact with power storage cell 100 with a thermally conductive member (an adhesive, a fixing member, or the like) being interposed therebetween.

As shown in Figs. 5 and 6, each cooling portion 210 includes an upstream flow path 211 and a downstream flow path 212.

Upstream flow path 211 is provided on the upstream side in the flow direction of the cooling medium. Downstream flow path 212 is provided on the downstream side in the flow direction of the cooling medium. As shown in Fig. 6, upstream flow path 211 and downstream flow path 212 each are shaped to extend in the first direction. Upstream flow path 211 and downstream flow path 212 are adjacent to each other in the second direction. The cooling medium flows through upstream flow path 211 from one side toward the other side in the first direction, and flows through downstream flow path 212 from the other side toward the one side in the first direction.

Folded portion 220 couples a downstream end of upstream flow path 211 and an upstream end of downstream flow path 212. Thus, as indicated by arrows in Fig. 6, the cooling medium flows through upstream flow path 211, folded portion 220, and downstream flow path 212 in this order.

Coupling portion 230 couples four cooling portions 210 to each other. As shown in Fig. 7, coupling portion 230 includes a coupling portion main body 232 and a partition wall 234.

Coupling portion main body 232 couples four cooling portions 210 to each other. Thus, the cooling media having flowed through respective downstream flow paths 212 merge with each other inside coupling portion main body 232. Coupling portion main body 232 may be formed in a substantially rectangular parallelepiped shape.

Partition wall 234 partitions the inside of coupling portion main body 232 into two spaces. In the present embodiment, as shown in Fig. 7, partition wall 234 divides the inside of coupling portion main body 232 into two parts in the upward-downward direction. An upstream end of each upstream flow path 211 is connected to a space above partition wall 234 (the space will be hereinafter referred to as an "upstream space S11") inside coupling portion main body 232, and a downstream end of each downstream flow path 212 is connected to a space below partition wall 234 (the space will be hereinafter referred to as a "downstream space S12") inside coupling portion main body 232. Thus, the cooling medium having flowed into upstream space S11 flows into each upstream flow path 211. The cooling medium having flowed out of each downstream flow path 212 flows into downstream space S12.

As shown in Figs. 6 and 7, an inflow portion 236 and an outflow portion 238 are connected to coupling portion 230.

Inflow portion 236 allows for communication between upstream space S11 inside coupling portion main body 232 and the outside of coupling portion main body 232. Thus, the cooling medium flows into upstream space S11 inside coupling portion main body 232 from the outside of coupling portion main body 232 through inflow portion 236. In the present embodiment, inflow portion 236 is connected to an upper surface of coupling portion main body 232.

Outflow portion 238 allows for communication between downstream space S12 inside coupling portion main body 232 and the outside of coupling portion main body 232. Thus, the cooling medium flows out of coupling portion main body 232 from downstream space S12 of coupling portion main body 232 through outflow portion 238. In the present embodiment, outflow portion 238 is connected to an upper portion of coupling portion main body 232 and partition wall 234. The cooling medium flowing out of coupling portion main body 232 through outflow portion 238 is higher in temperature than the cooling medium flowing into coupling portion main body 232 through inflow portion 236.

Facing member 700 faces the upper surface of cell case 120. More specifically, as shown in Fig. 5, facing member 700 faces separation surface 124 of cell case 120. Facing member 700 includes a weir portion 710. Weir portion 710 prevents moisture from flowing from separation surface 124 toward the outside in the second direction, i.e., toward external terminal 130.

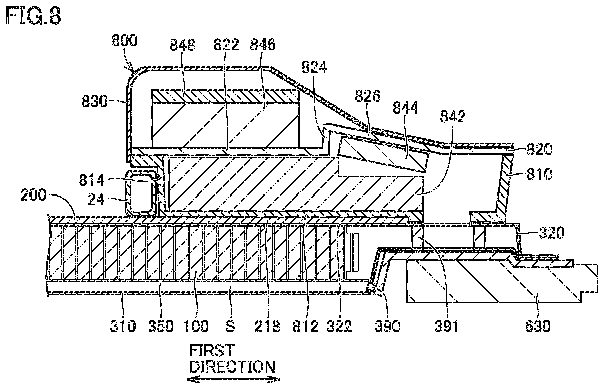

Device unit 800 is disposed, for example, at an end portion in the first direction. In the present embodiment, device unit 800 is disposed on a rear portion of upper cover 320 in the front-rear direction of vehicle 1. As shown in Fig. 8, device unit 800 includes a device base 810, a lid 820, a device cover 830, a junction box 842, an electronic control unit 844, an electricity supply unit 846, and a unit cooler 848. Note that Fig. 3 does not show electronic control unit 844 and unit cooler 848.

Device base 810 is provided on upper cover 320. Device base 810 is opened upward. As shown in Fig. 8, device base 810 has a bottom portion 812 and a rising portion 814.

Bottom portion 812 is disposed above upper cover 320. Bottom portion 812 supports junction box 842. Bottom portion 812 may be formed to be flat.

Rising portion 814 rises from a front end portion of bottom portion 812. Rising portion 814 faces second cross frame 24. Rising portion 814 is located behind second cross frame 24.

As shown in Figs. 3 and 8, a base support member 391 that supports device base 810 is disposed between lower case 310 and upper cover 320. A connector block 630 is disposed below base support member 391.

Junction box 842 is accommodated in device base 810. Junction box 842 is placed on bottom portion 812. Junction box 842 accommodates relays, fuses, and the like.

As shown in Figs. 3 and 8, cooler 200 includes an interposed portion 218 interposed between upper cover 320 and bottom portion 812 of device base 810. Interposed portion 218 is formed of a part of cooling portion 210. Junction box 842 is cooled by interposed portion 218. Interposed portion 218 is in thermal contact with junction box 842 with bottom portion 812 of device base 810 being interposed therebetween. A thermally conductive adhesive may be provided in at least one of: a portion between junction box 842 and bottom portion 812; and a portion between bottom portion 812 and interposed portion 218. Interposed portion 218 is in thermal contact with each power storage cell 100 with upper cover 320 and thermally conductive adhesive 910 being interposed therebetween.

Electronic control unit 844 is disposed above junction box 842.

Lid 820 is connected to an upper end portion of device base 810 so as to close the opening of device base 810. Together with device base 810, lid 820 accommodates junction box 842 and electronic control unit 844. Lid 820 includes a support portion 822, a step portion 824, and an inclined portion 826.

Support portion 822 is formed of a front portion of lid 820. Support portion 822 is formed to be flat.

Step portion 824 rises from a rear end portion of support portion 822. Step portion 824 is located in front of electronic control unit 844 and faces electronic control unit 844 in the front-rear direction (in the first direction).

Inclined portion 826 is inclined gradually downward from an upper end portion of step portion 824 toward the rear side. Inclined portion 826 is located above electronic control unit 844 and faces electronic control unit 844 in the upward-downward direction.

Electricity supply unit 846 is disposed on lid 820. As shown in Fig. 8, electricity supply unit 846 is placed on support portion 822 of lid 820.

Unit cooler 848 is disposed on electricity supply unit 846. Unit cooler 848 cools electricity supply unit 846.

Together with lid 820, device cover 830 accommodates electricity supply unit 846 and unit cooler 848. Device cover 830 is connected to device base 810.

In power storage device 10 described above, when gas is discharged downward from safety valve SV due to a short circuit or the like in any one of power storage cells 100, the gas breaks heat insulation plate 250 and flows into smoke discharge path S through the through hole h of spacer member 350. Thus, the contents (what is called debris) of power storage cell 100 that are contained in the gas are suppressed from adhering to external terminal 130 and the like of power storage cell 100.

The gas having flowed into smoke discharge path S spreads in the first direction and then is discharged from housing 300 through explosion-proof valve 390 as shown in Fig. 4. In this case, heat insulation plate 250 closes each through hole h positioned to face safety valve SV of each of other power storage cells 100 different from power storage cell 100 from which the gas has been discharged. Thereby, the gas spreading through smoke discharge path S is suppressed from coming into contact with valve installation surface 121 of each of these other power storage cells 100. Therefore, each power storage cell 100 other than power storage cell 100 from which gas has been discharged is suppressed from being heated by the gas.

Further, cooler 200 is provided on the upper surface of upper cover 320. Thus, even if the cooling medium leaks from cooler 200, the cooling medium is suppressed from coming into contact with power storage cell 100. Further, since cooler 200 forms a part of floor portion 30 of the vehicle cabin, the components constituting the floor portion of the vehicle cabin can be reduced from vehicle body 2.

Further, since cooler 200 includes interposed portion 218, both each power storage cell 100 and junction box 842 are cooled by single cooler 200.

It will be understood by those skilled in the art that the above-described exemplary embodiment is a specific example of the following aspects.

### [Aspect 1]

A power storage device including:
at least one power storage cell;
an upper cover disposed above the at least one power storage cell;
a cooler that cools the at least one power storage cell; and
a junction box provided above the upper cover, wherein
the cooler is in thermal contact with both the at least one power storage cell and the junction box.

In the present power storage device, both the power storage cell and the junction box are cooled by a single cooler. Therefore, the need to provide a dedicated cooler for cooling the junction box can be eliminated.

### [Aspect 2]

The power storage device according to Aspect 1, wherein the cooler is disposed above the upper cover.

In the present aspect, even if the cooling medium leaks from the cooler, the cooling medium is suppressed from coming into contact with the power storage cell.

### [Aspect 3]

The power storage device according to Aspect 2, further including a device base disposed on the upper cover to support the junction box, wherein
the cooler includes an interposed portion interposed between the upper cover and the device base, and
the interposed portion is in thermal contact with the at least one power storage cell with the upper cover being interposed therebetween, and is in thermal contact with the junction box with the device base being interposed therebetween.

### [Aspect 4]

The power storage device according to Aspect 3, further including:
an electronic control unit disposed above the junction box;
a lid that, together with the device base, accommodates the junction box and the electronic control unit;
an electricity supply unit placed on the lid;
a unit cooler that cools the electricity supply unit; and
a device cover that, together with the lid, accommodates the electricity supply unit and the unit cooler.

### [Aspect 5]

The power storage device according to any one of Aspects 1 to 4, further including:
a lower case that is opened upward and, together with the upper cover, accommodates the at least one power storage cell, the lower case including a bottom surface located below the at least one power storage cell; and
a spacer member provided between the bottom surface of the lower case and the at least one power storage cell to provide a space together with the bottom surface of the lower case, wherein
the at least one power storage cell includes
   an electrode assembly,
   a cell case that accommodates the electrode assembly, and
   a safety valve provided on a lower surface of the cell case, and
the spacer member has a through hole provided below the safety valve.

In the present aspect, the gas discharged downward from the safety valve of the power storage cell flows through the through hole into the space provided between the bottom surface of the lower case and the spacer member. Thus, the contents (what is called debris) of the power storage cell that are contained in the gas is suppressed from adhering to the power storage cell.

### [Aspect 6]

The power storage device according to Aspect 5, wherein
the at least one power storage cell includes a plurality of power storage cells,
each of the power storage cells further includes an external terminal electrically connected to the electrode assembly, and
the external terminal is provided on a side surface of the cell case in a second direction orthogonal to both an upward-downward direction and a first direction, the plurality of power storage cells being arranged side by side in the first direction.

In the present aspect, since the external terminal is provided on the side surface of the cell case, the power storage cell is reduced in height.

Although the embodiment of the present disclosure has been described, it should be understood that the embodiment disclosed herein is illustrative and non-restrictive in every respect. The scope of the present disclosure is defined by the terms of the claims, and is intended to include any modifications within the meaning and scope equivalent to the terms of the claims.

## Claims

1. A power storage device (10) comprising:
at least one power storage cell (100);
an upper cover (320) disposed above the at least one power storage cell (100);
a cooler (200) that cools the at least one power storage cell (100); and
a junction box (842) provided above the upper cover (320), wherein
the cooler (200) is in thermal contact with both the at least one power storage cell (100) and the junction box (842).

2. The power storage device (10) according to claim 1, wherein the cooler (200) is disposed above the upper cover (320).

3. The power storage device (10) according to claim 2, further comprising a device base (810) disposed on the upper cover (320) to support the junction box (842), wherein
the cooler (200) includes an interposed portion (218) interposed between the upper cover (320) and the device base (810), and
the interposed portion (218) is in thermal contact with the at least one power storage cell (100) with the upper cover (320) being interposed therebetween, and is in thermal contact with the junction box (842) with the device base (810) being interposed therebetween.

4. The power storage device (10) according to claim 3, further comprising:
an electronic control unit (844) disposed above the junction box (842);
a lid (820) that, together with the device base (810), accommodates the junction box (842) and the electronic control unit (844);
an electricity supply unit (846) placed on the lid (820);
a unit cooler (848) that cools the electricity supply unit (846); and
a device cover (830) that, together with the lid (820), accommodates the electricity supply unit (846) and the unit cooler (848).

5. The power storage device (10) according to any one of claims 1 to 4, further comprising:
a lower case (310) that is opened upward and, together with the upper cover (320), accommodates the at least one power storage cell (100), the lower case (310) including a bottom surface (312) located below the at least one power storage cell (100); and
a spacer member (350) provided between the bottom surface (312) of the lower case (310) and the at least one power storage cell (100) to provide a space together with the bottom surface (312) of the lower case (310), wherein
the at least one power storage cell (100) includes
an electrode assembly (110),
a cell case (120) that accommodates the electrode assembly (110), and
a safety valve (SV) provided on a lower surface of the cell case (120), and
the spacer member (350) has a through hole (h) provided below the safety valve.

6. The power storage device (10) according to claim 5, wherein
the at least one power storage cell (100) includes a plurality of power storage cells (100),
each of the power storage cells (100) further includes an external terminal (130) electrically connected to the electrode assembly (110), and
the external terminal (130) is provided on a side surface of the cell case (120) in a second direction orthogonal to both an upward-downward direction and a first direction, the plurality of power storage cells (100) being arranged side by side in the first direction.
